# EUROPEAN PATENT APPLICATION

(11) **EP 4 474 907 A1**
(43) Date of publication of application: **11.12.2024**
(21) Application number: 22924961.0
(22) Date of filing: 22.11.2022
(51) Int. Cl.: G03F 1/64, G03F 7/20, C23C 18/12

(54) **OPTICAL MEMBER AND PRODUCTION METHOD THEREFOR**

(30) Priority: 04.02.2022 JP 2022016181
(71) Applicant: Nippon Light Metal Company, Ltd., Tokyo 105-0004 (JP)
(72) Inventor: OSHIMA, Takeshi, Shizuoka-shi, Shizuoka 421-3203 (JP); SUZUKI, Norihito, Shizuoka-shi, Shizuoka 421-3203 (JP)
(74) Representative: Mewburn Ellis LLP
(86) International application number: PCT/JP2022/043142
(87) International publication number: WO 2023/149056

(57) **Abstract**

Provided are a lightweight optical member that can be manufactured at relatively low cost, the optical member having minimal distortion due to temperature increase and having excellent low dust generation and low outgassing properties. A pellicle frame (1) of the present invention is characterized by having a base material (4) composed of titanium or a titanium alloy and a TiO₂ coating layer (2) formed on the surface of the base material (4). The TiO₂ coating layer (2) preferably contains nitrogen.

## Description

### TECHNICAL FIELD

The present invention relates to an optical member such as a pellicle frame for a dust cover in an exposure process, which is essential in the manufacture of semiconductors, and a method for producing the same

### PRIOR ARTS

On the semiconductor device such as the LSI or the ultra LSI and the liquid crystal panel, a pattern can be formed by irradiating a light to a semiconductor wafer or an original plate for liquid crystal (pattern formation by lithography). Here, in the case of using an exposure master plate to which dust adheres, since the dust absorbs and/or inverts the light, the pattern is not transferred satisfactorily (for example, deformation of the pattern or ambiguity of the edge). As a result, the quality and appearance of the semiconductor device and the liquid crystal panel are impaired, which results in decrease in performance and manufacturing yield.

For this reason, the lithography process is usually performed in a clean room, but, since adhesion of dust to the exposure master plate cannot be completely prevented even under such environment, usually a pellicle for protecting from dust is provided on the surface of the exposure master plate. Pellicle is composed of a pellicle frame and a pellicle film stretched over the pellicle frame and is placed so as to surround a pattern area formed on the surface of the exposure master plate. When the focal point is set on the pattern of the exposure master plate at the time of lithography, even if dust adheres to the pellicle film, the dust will not affect the transfer.

Recently, the pattern of the LSI has been rapidly advanced to fineness, and accordingly, a wavelength of the exposure light source has been shortened. Specifically, the wavelength has transited from g-line (wavelength: 436 nm) and i-line (wavelength: 365 nm) of a mercury lamp to KrF excimer laser (wavelength: 248 nm), ArF excimer laser (wavelength: 193 nm), F₂ excimer laser (wavelength: 157 nm) and the like, and thus the flatness required for the exposure master plate and a silicon wafer has become more severe.

Since these short wavelength exposure light sources have high output and high energy of light, when an inorganic acid such as sulfuric acid or phosphoric acid remains on the anodized film formed on the surface of the aluminum material which forms the pellicle, there is a problem that a reaction product (haze) such as ammonium sulfate which is produced by reacting with a residual basic substance such as ammonia, and the reaction product causes clouding in the pellicle, which affects the pattern transferred image.

With respect to the problem, for example, Patent Literature 1 (JP 2010-237282 A) discloses a method for manufacturing a support frame for pellicles which is formed by an aluminum material including aluminum or an aluminum alloy and includes an optical thin film body used as a peliccle, and in the method, an anodized film is formed on a surface of the aluminum material by anodizing treatment with an alkaline aqueous solution containing tartaric acid, and the anodized film is subjected to dyeing treatment with an organic dye, and then is subjected to sealing treatment by steam to obtain a support frame for pellicles.

In the method for manufacturing the support frame for pellicles described in the above Patent Literature 1, by using the alkaline aqueous solution containing tartaric acid to anodize the aluminum material without using sulfuric acid which is the maximum causative substance of haze, it is said that there can be obtained a support frame for pellicles which can reduce the generation of haze as much as possible while having excellent corrosion resistance and durability.

Further, there is another problem with the pellicle frame body, if the pellicle frame body is significantly distorted due to thermal expansion, the exposure process cannot be carried out precisely. In particular, with regard to exposure equipment, under the demand for productivity improvement (throughput), the wavelength of the exposure light source is becoming shorter due to the increase in light source output and the miniaturization of circuit line width, and thus, there rises a distortion problem due to the temperature rise in the pellicle frame body placed in the optical path.

Conventionally, though aluminum has been used for the pellicle frame body because of its low specific gravity and good cutting processing, the pellicle frame body made of aluminum is liable to be distorted due to the temperature rise, because aluminum has a high linear expansion coefficient. Considering these problems, the material of the pellicle frame body is not limited to aluminum, and the use of ceramics, steel, or the like has also being studied.

For example, in Patent Literature 2 (JP 2016-177120 A), there is disclosed a pellicle frame formed in a frame shape, wherein the pellicle frame is composed of a sintered body having a Young's modulus of 150 GPa or more and a Vickers hardness of 800 or more, the corner portion in the frame shape is secured to have a width equal to or larger than the width of the straight portion, and at least one of the corner portions is wider than the width of the straight portion, and the pellicle frame is made of ceramics, cemented carbide or cermet.

Since the pellicle frame described in Patent Literature 2 uses a sintered body having a high Young's modulus and Vickers hardness, it is possible to suppress the deformation due to the film tension generated when the pellicle film is stretched and provided on the pellicle frame. Moreover, it is said that, since the width of at least one corner portion is wider than the width of the straight portion, the strength of the corner portion can be increased, and the deformation and damage of the pellicle frame can be further suppressed.

Further, in Patent Literature 3 (JP 2014-085453 A), there is disclosed a pellicle frame manufactured by press working from a single metal flat plate and has an L-shaped cross section, wherein the pellicle frame has a pellicle film adhesive surface on an outer surface bent at a right angle toward the outside from the inner wall surface of the pellicle frame and a mask adhesive surface on an end surface in contact with an inner wall surface, and the pellicle frame is made of carbon steel or stainless-steel.

It is said that, since the pellicle frame described in Patent Literature 3 is a pellicle frame manufactured by press working having excellent mass productivity, the manufacturing cost is extremely low, and since the pellicle frame is formed into the L-shaped cross section or the U-shaped cross section, the necessary and sufficient rigidity can be secured as a pellicle frame.

### CITATION LIST

### Patent Literature

Patent Literature 1: JP 2010-237282 A
Patent Literature 2: JP 2016-177120 A
Patent Literature 3: JP 2014-085435 A

### SUMMARY OF INVENTION

### Technical Problem

However, the pellicle frame body described in the above Patent Literature 1 is made of aluminum, and when an exposure light source with a shorter wavelength is used (when irradiating with an extreme ultraviolet ray), distortion due to an increase in temperature becomes a serious problem.

Further, the pellicle frame body described in Patent Literature 2 is made of a material having poor toughness and is very brittle, so that it is difficult to handle. Further, the workability is poor and the manufacturing cost becomes high. In addition, cemented carbide and cermet have a high specific gravity, which increases the weight of the pellicle frame body.

In addition, although the pellicle frame body described in Patent Literature 3 can be manufactured at low cost, carbon steel and stainless steel have a high specific gravity, and the weight of the pellicle frame body increases.

Furthermore, while the pellicle frame body is required to have low dust generation and low outgassing properties when irradiated with the extreme ultraviolet rays, it is difficult to say that the pellicle frames body described in the above Patent Literatures 1 to 3 fully meet these requirements.

In view of the problems in the prior arts as described above, the objects of the present invention are to provide an optical member such as a lightweight pellicle frame body that can be manufactured at relatively low cost, the optical member having minimal distortion due to temperature increase and having excellent low dust generation and low outgassing properties, and to provide a method for efficiently manufacturing the same.

### Solution to Problem

As a result of extensive study with respect to the materials and surface conditions and the like of the optical member in order to achieve the above object, the present inventors have found that it is extremely effective in using titanium or a titanium alloy as a raw material and forming a TiO₂ coating layer on the surface by a sol-gel method, the present invention has been completed.

Namely, the present invention provides an optical member, which comprises:
a base member made of titanium or a titanium alloy, and
a TiO₂ coating layer formed on the surface of the base member.

The optical member of the present invention has both light weight and low thermal expansion properties, since the base material is made of titanium or the titanium alloy. Further, since the TiO₂ coating layer is formed on the entire surface of the base material, it has excellent low dust generation and low outgassing properties. In addition, the TiO₂ coating layer also provides the optical element of the present invention with good hydrogen plasma resistance.

The TiO₂ coating layer not only has the effect of trapping foreign matters present on the surface of the base material to suppress their detachment, but also, because the coating layer is a dense and stable ceramic layer, almost no outgassing is generated even when exposed to extreme ultraviolet rays.

In the optical member of the present invention, it is preferable that the TiO₂ coating layer contains nitrogen. The nitrogen comes from a salt catalyst when the TiO₂ coating layer is formed by using the sol-gel method. The use of the salt catalyst effectively promotes the polycondensation reaction of Ti alkoxide, which is the raw material for the TiO₂ coating layer to form a dense and homogeneous TiO₂ coating layer, thereby more reliably ensuring the trapping effect of foreign matters and low outgassing properties.

Further in the optical member of the present invention, it is preferable that a through hole is present in the base material, and the TiO₂ coating layer is also formed on the inner surface of the through hole. When the base material has the through hole, it is extremely difficult to completely remove the foreign matters adhering to the inner surface of the through hole, but, in the optical member of the present invention, since the dense and homogeneous TiO₂ coating layer is formed on the inner surface of the through hole by the sol-gel method, excellent low dust generation is ensured.

Further, in the optical member of the present invention, it is preferable that the amount of hydrogen gas generated by irradiation with the extreme ultraviolet ray is 1.2 times or less than the amount of hydrogen gas generated when the base material is irradiated with the extreme ultraviolet ray under the same conditions. The TiO₂ coating layer formed on the surface of the optical member of the present invention is a dense, homogeneous, and chemically stable ceramic layer, and even when irradiated with the extreme ultraviolet ray, the amount of outgassing generated from the TiO₂ coating layer is extremely small. As a result, the amount of hydrogen gas generated by irradiation with the extreme ultraviolet ray can be reduced to 1.2 times or less the amount of hydrogen gas generated when the base material is irradiated with the extreme ultraviolet ray under the same conditions. The amount of hydrogen gas generated is more preferably 1.1 times or less, and most preferably 1.05 times or less.

Further, in the optical member of the present invention, it is preferable that, when the optical member is immersed in 3 L of pure water and irradiated with an ultrasonic wave for 1 minute, the number of particles having a particle size of 1 to 15 pm present in 50 ml of the pure water is 600 particles / 68 cm² or less. In the optical member of the present invention, since the foreign matter is trapped by the dense and homogeneous TiO₂ coating layer formed on the surface of the base material, the detachment of the foreign matter (particles) is extremely effectively suppressed even in the harsh conditions in which the optical member is immersed in pure water and irradiated with the ultrasonic wave.

Further, in the optical member of the present invention, it is preferable that, when the optical member is immersed in 3 L of pure water and irradiated with an ultrasonic wave for 1 minute, the number of particles having a particle size of 0.5 to 1 pm present in 50 ml of the pure water is 2000 particles / 68 cm² or less. In the optical member of the present invention, since the foreign matter is trapped by the dense and homogeneous TiO₂ coating layer formed on the surface of the base material, the detachment of the foreign matter (particles) is extremely effectively suppressed even in the harsh conditions in which the optical member is immersed in pure water and irradiated with the ultrasonic wave.

The optical member of the present invention is preferably a pellicle frame, but is not particularly limited as long as the effects of the present invention are not impaired, and for example, may be any of various conventionally known optical parts (such as a housing, various support parts inside the housing, shutter blades, and apertures) that constitute optical devices such as digital cameras, digital video cameras, and camera-equipped mobile phones.

The present invention also provides a method for producing an optical member, comprising:
a step for preparing a base material for an optical member, in which the base material made of titanium or a titanium alloy is processed into the shape of the base material for the optical member; and
a coating step for forming a TiO₂ coating layer on the surface of the base material for the optical member by a sol-gel method,
wherein a nitrogen-containing salt catalyst is used in the coating step.

The method for producing an optical member of the present invention is characterized in that (1) the base material for the optical member is made of titanium or the titanium alloy, (2) the sol-gel method is used, and (3) the nitrogen-containing salt catalyst is used in the sol-gel method. In particular, by using the salt catalyst, a dense and homogeneous TiO₂ coating layer can be efficiently formed over the entire surface of the base material.

Further, in the method for producing an optical member of the present invention, it is preferable that a through hole is formed in the base material for the optical member in the preparing step of the base material for the optical member, and that the TiO₂ coating layer is also formed on the inner surface of the through hole in the coating step. Since the sol-gel method is used in the method for producing an optical member of the present invention, the TiO₂ coating layer can be easily formed even inside the through holes. In particular, by applying dip coating, the TiO₂ coating layer can be easily and efficiently formed inside the through hole.

In addition, in the method for producing an optical member of the present invention, the polycondensation reaction of the coating raw material is promoted by using a nitrogen-containing salt catalyst, and even when the TiO₂ coating layer is formed by low-temperature sintering at approximately 200 to 300°C, the crystallization of TiO₂ is promoted. As a result, the finally obtained TiO₂ coating layer can be a good ceramic layer with a high degree of crystallinity.

### EFFECT OF THE INVENTION

According to the present invention, it is possible to provide the optical member such as a lightweight pellicle frame body that can be manufactured at relatively low cost, the optical member having minimal distortion due to temperature increase and having excellent low dust generation and low outgassing properties, and to provide a method for efficiently producing the same.

### BRIEF DESCRIPTION OF THE DRAWINGS

FIG. 1 is a perspective view of the pellicle frame according to the embodiment.
FIG. 2 is a cross-sectional view of the pellicle frame body of the embodiment along line C-C'.
FIG. 3 is a process diagram of the method for producing the pellicle frame body according to the embodiment.
FIG. 4 is a SEM photograph of the present pellicle frame body 1.
FIG. 5 is a SEM photograph of the present pellicle frame body 2.
FIG. 6 is a SEM photograph of the comparative pellicle frame body 1.
FIG. 7 is a SEM photograph of the comparative pellicle frame body 2.
FIG. 8 is a SEM photograph of the comparative pellicle frame body 4.
FIG. 9 is an IR spectrum of the present pellicle frame body 1.
FIG. 10 is an IR spectrum of the present pellicle frame body 2.
FIG. 11 is an IR spectrum of the comparative pellicle frame body 1.
FIG. 12 is an IR spectrum of the comparative pellicle frame body 2.
FIG. 13 is an IR spectrum of the comparative pellicle frame body 4.
FIG. 14 is the measurement result of hydrogen gas.
FIG. 15 is the measurement results of water and ammonia.
FIG. 16 is the measurement results of hydrocarbons.

### Embodiments for achieving the invention

Hereinafter, a pellicle frame body will be taken up as a typical embodiment of the optical member, typical embodiments of the optical member and the manufacturing method thereof according to the present invention will be described in detail with reference to the drawings, but the present invention is not limited to only these examples. Further, the elements in the embodiment can be optionally combined with a part or the whole. In the following description, the same or equivalent parts are denoted by the same numerals, and there is a case that redundant explanation may be omitted. In addition, since the drawings are for conceptually explaining the present invention, dimensions of the respective constituent elements expressed and ratios thereof may be different from actual ones.

### 1. Pellicle frame body

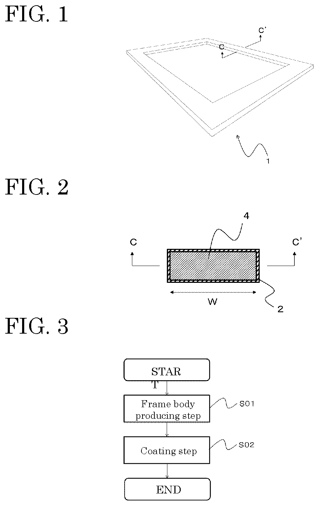

As shown in FIGS. 1 and 2, the pellicle frame body 1 is constituted of a frame body 4 made of titanium or the titanium alloy having the TiO₂ coating layer 2 on the surface.

Since the frame body 4 is made of titanium or the titanium alloy, it has high strength and Young's modulus in comparison with a pellicle frame body made of an aluminum alloy which is generally used in the past. Further, since the specific gravity of titanium and the titanium alloy is relatively light, about 4.5, the weight increase of the pellicle frame body 1 can be suppressed.

The titanium alloy used for the frame body 4 is not particularly limited as long as the effect of the present invention is not impaired, and various conventionally known titanium alloys can be used. Examples of the titanium alloys include Ti-6Al-4V alloy, Ti-6Al-6V-2Sn alloy, Ti-6Al-2Sn-4Zr-6Mo alloy, Ti-10V-2Fe-3Al alloy, Ti-7Al-4Mo alloy, Ti-5Al-2.5Sn alloy, Ti-6Al-5Zr-0.5Mo-0.2Si alloy, Ti-5.5Al-3.5Sn-3Zr-0.3Mo-1Nb-0.3Si alloy, Ti-8Al-1Mo-1V alloy, Ti-6Al-2Sn-4Zr-2Mo alloy, Ti-5Al-2Sn-2Zr-4Mo-4Cr alloy, Ti-11.5Mo-6Zr-4.5Sn alloy, Ti-15V-3Cr-3Al-3Sn alloy, Ti-15Mo-5Zr-3Al alloy, Ti-15Mo-5Zr alloy, and Ti-13V-11Cr-3Al alloy.

From the viewpoint of ensuring good workability and purity, it is preferable to use titanium (pure titanium), from the viewpoint of achieving both high strength and good processing ability, it is preferable to use an α + β type alloy, and from the viewpoint of material price and availability, it is more preferable to use a Ti-6Al-4V alloy.

The shape of the pellicle frame body 1 is not particularly limited as long as the effect of the present invention is not impaired, and various conventionally known shapes can be used depending on the shape of the light exposure original plate, and in general, the planar shape of the pellicle frame body 1 is a ring shape, a rectangular shape, or a square shape, and has a size and a shape that cover a circuit pattern portion provided on the light exposure original plate.

The height (thickness) of the pellicle frame body 1 is preferably 0.5 to 10 mm, more preferably 1 to 7 mm, and most preferably 1.0 to 3.0 mm. By setting the height (thickness) of the pellicle frame body 1 to these values, deformation of the pellicle frame body 1 can be suppressed and good handleability can be ensured.

The cross-sectional shape of the pellicle frame body 1 is not particularly limited as long as the effect of the present invention is not impaired, and may be various conventionally known shapes, and preferable is a quadrilateral where the upper side and the lower side are parallel. The upper side of the pellicle frame body 1 needs a width for stretching the pellicle film, and the lower side needs a width for providing an adhesive layer for adhesion and adhering to the light exposure original plate. For this reason, the width (W) of the upper side and the lower side of the pellicle frame body 1 is preferably around 1 to 3 mm.

The flatness of the pellicle frame body 1 is preferably 30 pm or less, more preferably 20 pm or less. By improving the flatness of the pellicle frame body 1, the amount of deformation of the light exposure original plate when the pellicle is attached to the light exposure original plate can be reduced. The flatness of the pellicle frame body 1 is determined by measuring the height at four points at each corner of the pellicle frame body 1 and four points at the center of the four sides, i.e. eight points in total, to calculate a virtual plane, and then calculating from a difference obtained by subtracting the lowest point from the highest point among the distances of each point from the virtual plane.

The TiO₂ coating layer 2 is formed by the sol-gel method, and it is preferable that the TiO₂ coating layer 2 contains nitrogen. The nitrogen comes from a salt catalyst when the TiO₂ coating layer 2 is formed by using the sol-gel method. The use of the salt catalyst effectively promotes the polycondensation reaction of Ti alkoxide, which is the raw material for the TiO₂ coating layer 2 to form a dense and homogeneous TiO₂ coating layer 2, thereby more reliably ensuring the trapping effect of foreign matters and low outgassing properties. Here, the method for detecting the nitrogen is not particularly limited, and various conventionally known elemental analysis methods can be used.

The TiO₂ coating layer 2 is formed on the entire surface of the frame body 4, and the thickness is not particularly limited as long as the effects of the present invention are not impaired, and it is preferably 10 nm to 50 pm.

Further, the through hole (not shown) is present in the pellicle frame body 1, and it is preferable that the TiO₂ coating layer 2 is also formed on the inner surface of the through hole. When the frame body 4 has the through hole, it is extremely difficult to completely remove the foreign matters adhering to the inner surface of the through hole, but, since the dense and homogeneous TiO₂ coating layer 2 is formed on the inner surface of the through hole, excellent low dust generation can be ensured.

In the pellicle frame body 1, it is preferable that the amount of hydrogen gas generated by irradiation with the extreme ultraviolet ray is 1.2 times or less than the amount of hydrogen gas generated when the frame body 4 is irradiated with the extreme ultraviolet ray under the same conditions. The TiO₂ coating layer 2 is a dense, homogeneous, and chemically stable ceramic layer, and even when irradiated with the extreme ultraviolet ray, the amount of outgassing generated from the TiO₂ coating layer 2 is extremely small. As a result, the amount of hydrogen gas generated by irradiation with the extreme ultraviolet ray can be reduced to 1.2 times or less the amount of hydrogen gas generated when the frame body 4 is irradiated with the extreme ultraviolet ray under the same conditions. The amount of hydrogen gas generated is more preferably 1.1 times or less, and most preferably 1.05 times or less.

Further, with regard to the outgassing during irradiation with the extreme ultraviolet ray, it is not only hydrogen gas that is suppressed from being generated, for example, the generation of hydrocarbon gases such as C₃H₅ is also effectively suppressed. The method for measuring the amount of the outgassing is not particularly limited, and any of various conventionally known gas analysis methods can be used.

Further, in the pellicle frame body 1, it is preferable that, when the frame body is immersed in 3 L of pure water and irradiated with an ultrasonic wave for 1 minute, the number of particles having a particle size of 1 to 15 pm present in 50 ml of the pure water is 600 particles / 68 cm² or less. In the pellicle frame body 1, since the foreign matter is trapped by the dense and homogeneous TiO₂ coating layer 2 formed on the surface of the frame body 4, the detachment of the foreign matter (particles) is extremely effectively suppressed even in the harsh conditions in which the pellicle frame body 1 is immersed in pure water and irradiated with the ultrasonic wave.

Here, when the pellicle frame body 1 is immersed in 3 L of pure water and irradiated with the ultrasonic wave for 1 minute, the particles that are prevented from detaching are not limited to those having a particle size of 1 to 15 pm, and, for example, the number of particles present in 50 ml of pure water is preferably 2000 particles / 68 cm² or less when the particle size is 0.5 to 1 pm.

### 2. Method for producing pellicle frame body

As shown in FIG. 3, the method for producing the pellicle frame body of the present embodiment includes a frame body (base material for optical member) preparing step (S01) where a base material made of titanium or the titanium alloy is processed into the shape of the frame body 4, and a coating step (S02) where the TiO₂ coating layer 2 is formed on the surface of the frame body 4 by the sol-gel method. Hereinafter, each step including any optional step will be described in detail.

### (1) Frame body preparing step (S01)

The frame body manufacturing step (S01) is a step for obtaining the frame body 4, and is a step for obtaining the frame body 4 of the pellicle frame body 1 with high dimensional accuracy, as occasion demand, by subjecting the titanium or titanium alloy member to the joining and cutting process.

When the titanium or the titanium alloy material has a sufficient size, the frame body 4 can be cut out from the material. On the other hand, the frame body 4 can also be obtained by joining titanium or a titanium alloy member, and in this case, the yield of titanium or the titanium alloy member can be increased. Here, it is preferable to use solid-phase welding for joining the titanium or a titanium alloy member. By using the solid-phase welding, the strain generated at the joint portion can be suppressed, and the difference in mechanical properties between the joint portion and the base metal can be reduced. The frame body 4 obtained by cutting or joining may be further subjected to the cutting process.

Further, a through hole is formed in the frame body 4, and it is preferable to also form the TiO₂ coating layer 2 on the inner surface of the through hole in the coating step (S02). Since the sol-gel method is used in the coating step (S02), the TiO₂ coating layer 2 can be easily formed even inside the through hole.

### (2) Coating step (S02)

The coating step (S02) is a step for forming the TiO₂ coating layer 2 on the surface of the frame body 4 obtained in the base material preparing step (S01).

As a pretreatment for the coating step (S02), it is preferable to perform a degreasing treatment on the frame body 4. Specifically, the oil components can be removed from the frame body 4 by washing with acetone or the like, then washing with pure water, and then dried. Further, in order to smooth the surface, it is preferable to subject the frame body 4 to chemical polishing.

Next, a Ti alkoxide is used as the raw material for the TiO₂ coating layer 2, and the TiO₂ coating layer 2 can be formed on the surface of the frame body 4 by hydrolysis and polycondensation reaction of the Ti alkoxide. The method for applying the Ti alkoxide to the surface of the frame body 4 is not particularly limited as long as the effects of the present invention are not impaired, and it is preferable to immerse the frame body 4 (dip coating). By applying the dip coating, the TiO₂ coating layer 2 can be formed simply and efficiently.

The morphology of the TiO₂ coating layer 2 varies depending on the extent to which the Ti alkoxide is hydrolyzed and then polymerized. Specifically, suppressing the hydrolysis and promoting the polycondensation results in low-dimensional growth, whereas promoting the hydrolysis and suppressing the polycondensation results in high-dimensional growth. Here, since gelation occurs in the case of low-dimensional growth, it is preferable to promote the polycondensation when using the Ti alkoxide having a slow polycondensation rate, as the raw material.

Further, a nitrogen-containing salt catalyst is used in the process of forming the TiO₂ coating layer 2 by using the sol-gel method. The polycondensation reaction can be accelerated by using the nitrogen-containing salt catalyst.

Further, by heating the Ti alkoxide gelled on the surface of the frame body 4 at a low temperature, the dense and homogeneous TiO₂ coating layer 2 can be obtained. The heating temperature is not particularly limited as long as the effects of the present invention are not impaired, and may be appropriately adjusted depending on the desired state of the TiO₂ coating layer 2, but it is preferable to perform low-temperature heating at 200 to 300°C. The polycondensation reaction of the Ti alkoxide is promoted by using the salt catalyst, and even when the TiO₂ coating layer is formed by the low-temperature sintering at about 200 to 300°C, the crystallization of TiO₂ is promoted. As a result, the finally obtained TiO₂ coating layer 2 can be a good ceramic layer having a high degree of crystallinity.

The representative embodiments of the present invention have been described above, but the present invention is not limited only to these embodiments, and various design changes are possible, and all such design changes are included in the technical scope of the present invention.

### EXAMPLES

### «Example 1»

A base material for an optical members of 50 mm x 50 mm x 1.5 mm was cut out from a pure titanium plate having a thickness of 2 mm (step for producing base material for optical member), and the surface was smoothed by chemical polishing. Next, a TiO₂ coating layer was formed on the entire surface of the frame body by the sol-gel method by using a Ti alkoxide as a raw material (coating step). The coating step used a nitrogen-containing salt catalyst, and the gelled Ti alkoxide layer was formed on the entire surface of the frame body by the dip coating. The frame body was immersed in the raw material at a speed of 5 mm/s and withdrawn at a speed of 1 mm/s.

Next, the frame body having the gelled Ti alkoxide layer formed on the entire surface was sintered at 300°C for 2 hours to form a TiO₂ coating layer, thereby obtaining the present pellicle frame body 1 which is an embodiment of the present invention. The thickness of the TiO₂ coating layer was observed by cross-sectional observation and found to be 20 to 30 nm.

### «Example 2»

The present pellicle frame 2 was obtained in the same manner as in Example 1, except that the sintering temperature was 200°C.

### <<Comparative Example 1>>

The comparative pellicle frame body 1 was obtained in the same manner as in Example 1, except that the entire surface of the frame body was dip-coated with "Honeycelan PI-20" available from Honey Chemical Co., Ltd. and the sintering conditions were 150°C for 1 hour.

"Honeyceran PI-20" is a one-component sintering paint for glass materials whose main component is polysiloxane resin, and a SiO₂ coating layer was formed on the surface of the frame body by the sintering.

### <<Comparative Example 2>>

The comparative pellicle frame body 2 was obtained in the same manner as in Example 1, except that the entire surface of the frame body was dip-coated with "Sancerazane #200-1" available from Sanwa Chemical Co., Ltd. and the sintering conditions were 150°C for 1 hour.

"Sanserazan #200-1" is a mixture of 1% inorganic polysilazane and 90 to 99% dibutyl ether, and a SiO₂ coating layer was formed on the surface of the frame by the sintering.

### <<Comparative Example 3>>

The comparative pellicle frame body 3 was obtained in the same manner as in Example 1, except that the chemical polishing and coating treatment were not performed.

### <<Comparative Example 4>>

The comparative pellicle frame body 4 was obtained in the same manner as in Example 1, except that no coating treatment was applied.

### [Evaluation]

### (1) Change in surface morphology due to irradiation with extreme ultraviolet ray

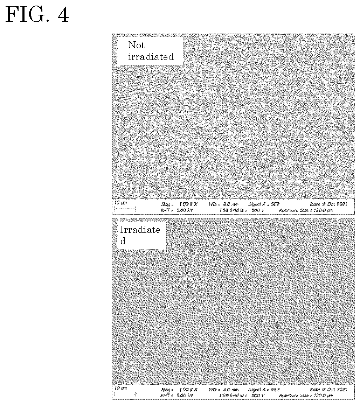

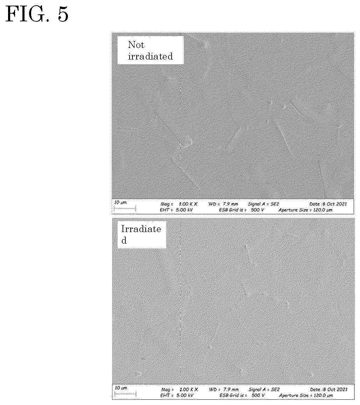

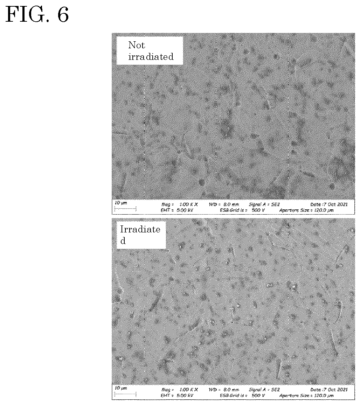

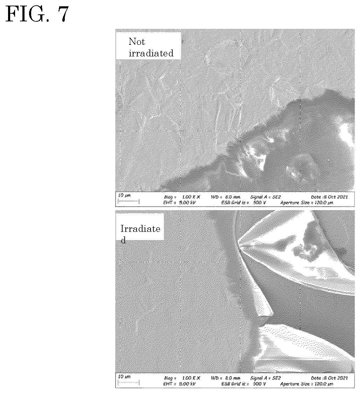

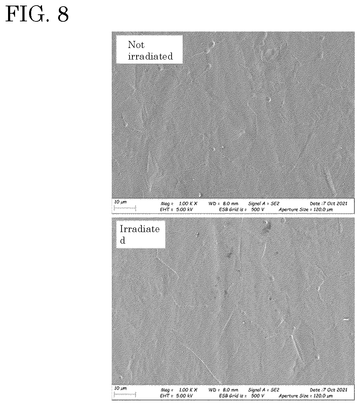

The surface of each pellicle frame body was irradiated with the extreme ultraviolet ray of 4 W/cm² for 30 minutes, and the surface condition before and after exposure was observed by using a scanning electron microscope (ULTRA PLUS, available from Carl Zeiss). SEM photographs of the present pellicle frame body 1, the present pellicle frame body 2, the comparative pellicle frame body 1, the comparative pellicle frame body 2 and the comparative pellicle frame body 4 are shown in FIG. 4, FIG. 5, FIG. 6, FIG.7 and FIG. 8, respectively.

In the present pellicle frame body 1 and the present pellicle frame body 2, no crack or the like was generated by the irradiation with the extreme ultraviolet ray, and a good surface condition was maintained. On the other hand, in the comparative pellicle frame bodies, the coating layer was non-uniform even before the irradiation, and it was found that the filmforming properties were poor. In addition, for the comparative pellicle frame body 2, peeling of the coating layer due to the irradiation was also observed.

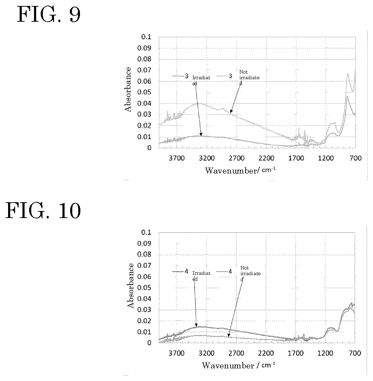

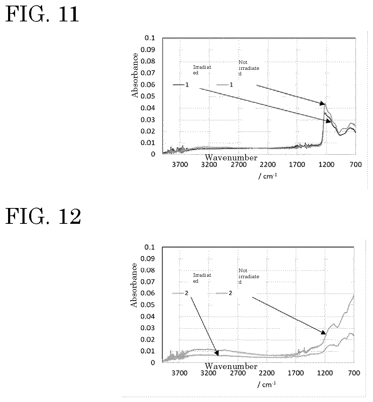

The IR spectrum was measured for the surface before and after the irradiation with the extreme ultraviolet ray. The measurements were performed by using the FT-IR 660-IR / 620-IR available from Agilent Technologies. The IR spectra of the present pellicle frame body 1, the present pellicle frame body 2, the comparative pellicle frame body 1, the comparative pellicle frame body 2 and the comparative pellicle frame body 4 are shown in FIG. 9, FIG. 10, FIG. 11, FIG. 12 and FIG. 13, respectively.

In the present pellicle frame body 1 and the present pellicle frame body 2, no significant change was observed in the IR spectrum due to the irradiation with the extreme ultraviolet ray, and it is clear that good surface conditions were maintained.

### (2) Measurement of outgassing due to irradiation with extreme ultraviolet ray

Each pellicle frame body was placed in a vacuum chamber and a vacuum was drawn. Next, measurements were carried out in the range of 1 to 200 amu before irradiation with the extreme ultraviolet ray. Next, after the irradiation with the extreme ultraviolet ray of 4 W/cm², mass peak measurement was carried out for 12 minutes in the range of 1 to 200 amu. Next, different areas were irradiated with the extreme ultraviolet ray and the temporal change was measured at a specific amu (0 to 30 min).

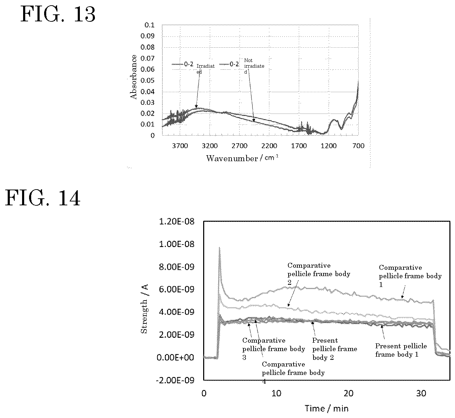

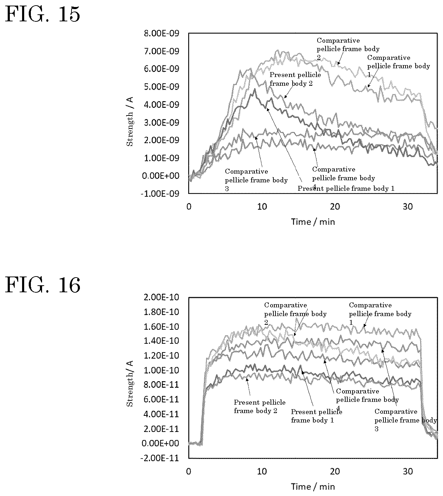

The measurement results for the hydrogen gas are shown in FIG. 14, the measurement results for the water and ammonia are shown in FIG. 15, and the measurement results for the hydrocarbons are shown in FIG. 16, respectively. With respect to the hydrogen gas and hydrocarbons, it can be seen that the gas emissions from the present pellicle frame body 1 and the present pellicle frame body 2 on which the TiO₂ coating layer is formed are significantly reduced. Further, with respect to the water and ammonia, the discharged amounts were also significantly reduced compared to the case where the SiO₂ coating layer was formed, although it was still inferior to the case where no coating was applied.

### (3) Evaluation of amount of dust generation

The amount of dust generation was evaluated by liquid particle evaluation. Specifically, a glass beaker was ultrasonically cleaned with pure water, and then 3 L of pure water was poured into the beaker, and a blank value was measured by using a liquid particle counter (NP500T, available from Nippon Denshoku Industries Co., Ltd.).

Next, the pellicle frame body was immersed in the pure water and subjected to ultrasonic irradiation for one minute. Thereafter, the pellicle frame body was removed, and the number of particles in 50 ml of pure water was measured by using the liquid particle counter. The results obtained are shown in Table 1. The values in Table 1 are converted values (particles / 68 cm²).

**[Table 1]**

| | Number of particles with 0.5 to 1 µm particle size | Number of particles with 1 to 2 µm particle size | Number of particles with 2 to 3 µm particle size | Number of particles with 3 to 5 µm particle size | Number of particles with 5 to 15 µm particle size | Number of particles with 15 µm or more particle size |
|---|---|---|---|---|---|---|
| Present pellicle frame body 2 | 1208 | 288 | 6 | 17 | 6 | 0 |
| Comparative pellicle frame body 1 | 4625 | 1135 | 33 | 99 | 28 | 0 |
| Comparative pellicle frame body 2 | 8762 | 1207 | 12 | 18 | 4 | 0 |
| Comparative pellicle frame body 3 | 114309 | 7285 | 61 | 172 | 42 | 0 |
| Comparative pellicle frame body 4 | 3355 | 705 | 16 | 60 | 23 | 1 |

When the SiO₂ coating layer was formed (comparative pellicle frame body 1 and comparative pellicle frame body 2), no reduction in the amount of dust generation was observed due to the formation of the coating layer, and rather the amount of dust generation tended to increase compared to the state where only chemical polishing was performed (comparative pellicle frame body 4). In contrast, it can be seen that the amounts of dust generation of the present pellicle frame body 1 and the present pellicle frame body 2 on which the TiO₂ coating layer was formed were significantly reduced.

### (4) Evaluation of ion elution amount

The pellicle frame body was immersed in 100 ml of pure water stored in a polyethylene bag, placed in a water bath at 90°C, and left to stand for 3 hours. Thereafter, the frame body was transferred to a water bath at room temperature to cool, and the amount of ions in the pure water (pellicle frame body immersed liquid) was measured by an ion chromatography (anions) and absorptiometry (NH₄). Thermo Integration RFIC was used for the ion chromatography, and Spectrophotometer V-630 available from JASCO was used for the absorptiometry. The results obtained are shown in Table 2.

**[Table 2]**

| | | | | | | | (Unit ppb/68cm²) | | |
|---|---|---|---|---|---|---|---|---|---|
| | Anion | | | | | | | | Cation |
| | Acetic acid | Formic acid | Cl | NO₂ | NO₃ | SO₄ | Oxalic acid | PO₄ | NH₄ |
| Present pellicle frame body 2 | <10 | 3 | <2 | <2 | <5 | <5 | <5 | <10 | 10 |
| Comparative pellicle frame body 1 | <10 | 2 | <2 | <2 | <5 | <5 | <5 | <10 | 10 |
| Comparative pellicle frame body 2 | 12 | 2 | <2 | <2 | <5 | <5 | <5 | <10 | 10 |
| Comparative pellicle frame body 3 | <10 | 5 | <2 | <2 | <5 | <5 | <5 | <10 | <10 |
| Comparative pellicle frame body 4 | <10 | 4 | <2 | <2 | <5 | <5 | <5 | <10 | <10 |
| (Lower limit) | 10 | 2 | 2 | 2 | 5 | 5 | 5 | 10 | 10 |

In the present pellicle frame body 1 and present pellicle frame body 2 on which the TiO₂ coating layer was formed, no significant increase in the amount of ion elution was observed, and it can be seen that the pellicle frame body of the present invention has good characteristics in terms of the amount of ion elution.

### BRIEF EXPLANATION OF THE SYMBOLES

- 1: Pellicle frame body,
- 2: TiO₂ coating layer,
- 4: Frame body.

## Claims

1. An optical member, which comprises:
a base material made of titanium or a titanium alloy, and
a TiO₂ coating layer formed on the surface of the base material.

2. The optical member according to claim 1, wherein the TiO₂ coating layer contains nitrogen.

3. The optical member according to claim 1 or 2, wherein
a through hole is present in the base material, and
the TiO₂ coating layer is also formed on the inner surface of the through hole.

4. The optical member according to claim 1 or 2, wherein an amount of hydrogen gas generated by irradiation with the extreme ultraviolet ray is 1.2 times or less than the amount of hydrogen gas generated when the base material is irradiated with the extreme ultraviolet ray under the same conditions.

5. The optical member according to claim 1 or 2, wherein, when the optical member is immersed in 3 L of pure water and irradiated with an ultrasonic wave for 1 minute, the number of particles having a particle size of 1 to 15 pm present in 50 ml of the pure water is 600 particles / 68 cm² or less.

6. The optical member according to claim 1 or 2, wherein, when the optical member is immersed in 3 L of pure water and irradiated with an ultrasonic wave for 1 minute, the number of particles having a particle size of 0.5 to 1 pm present in 50 ml of the pure water is 2000 particles / 68 cm² or less.

7. A method for producing an optical member, comprising:
a step for preparing a base material for an optical member, in which the base material made of titanium or a titanium alloy is processed into the shape of the base material for the optical member; and
a coating step for forming a TiO₂ coating layer on the surface of the base material for the optical member by a sol-gel method,
wherein a nitrogen-containing salt catalyst is used in the coating step.

8. The method for producing an optical member according to claim 7, wherein
a through hole is formed in the base material for the optical member in the preparing step of the base material for the optical member, and
the TiO₂ coating layer is also formed on the inner surface of the through hole in the coating step.
